# EUROPEAN PATENT APPLICATION

(11) **EP 3 373 348 A1**
(43) Date of publication of application: **12.09.2018**
(21) Application number: 17159918.6
(22) Date of filing: 08.03.2017
(51) Int. Cl.: H01L 35/32

(54) **THERMOELECTRIC DEVICE**

(71) Applicant: Blunergy SA, 1091 Bourg-en-Lavaux (CH)
(72) Inventor: BORHANI, Navid, 1094 Paudex (CH); SOLIGNAC, Dominique, 1305 Penthalaz (CH); KAEUPER, Peter, 1003 Lausanne (CH); MOSSIER, Evan, 1004 Lausanne (CH); ROSSI, Nathanaël, 1110 Morges (CH)
(74) Representative: Schneiter, Sorin

(57) **Abstract**

The present invention provides a thermoelectric device comprising corrugated strips of thin thermoelectric elements that are sandwiched between two plates or attached to a single backing plate. The thermoelectric couples and strips are electrically connected in series and thermally in parallel. The design of this invention allows relatively cheaper, lighter, and larger area thermoelectric generators to be manufactured, thus allowing electrical energy to be more economically harvested from waste heat or ambient sources. Furthermore, the design of the invention allows it to be efficiently manufactured.

## Description

### Technical Field

The present invention relates to a thermoelectric device, in particular a device exploiting the Peltier-Seebeck effect. In a particular aspect, the invention concerns a thermoelectric generator (TEG), to methods for fabricating the devices, and to the use of strips comprising alternating materials in the aforementioned devices.

### Background Art, Problems and Goals to be Achieved by the Invention

The ever-increasing energy demands of industry and society have resulted in the search for renewable ecological sources of cheap electrical energy. One of the main avenues of this research has been the conversion of thermal energy, that is freely available from the ambient surroundings or dissipated by machines or organisms, into electrical energy.

One solution for this conversion is the use of thermoelectric generators that directly convert thermal energy into electrical energy using the Seebeck-Peltier phenomenon. Such thermoelectric generators typically comprise blocks of two thermoelectric materials with different Seebeck coefficients that are alternately connected in series to form individual thermoelectric couples. These thermoelectric couples are then connected in series, typically in a regular array, and sandwiched between two rigid electrically insulating plates to produce a thermoelectric generator. When a thermal gradient is applied between the two faces of the generator, the thermocouples in contact with the hot side form the hot junctions whilst those in contact with the cold side form the cold junctions, such that the voltage generated by the thermoelectric generator is proportional to the temperature difference between the hot and cold junctions.

However, due to their design and cost, such thermoelectric generators are expensive, heavy, and limited to devices with small surface areas. As a result of this, they are not suited to the economical generation of electricity from solar radiation that is incident on large surface areas, for example in combination with present photovoltaic cells or as standalone solar collectors. Furthermore, their design does not allow them to be fabricated cheaply and rapidly in large volumes.

It is an objective of the present invention to address the problems depicted above, thus providing a new design for thermoelectric devices that results in lighter and larger area devices, which can be manufactured in a commercially viable manner.

### Summary of the Invention

Remarkably, the present inventors provide a thermoelectric device comprising a strip, sheet and/or film comprising first and second materials, wherein said first material has a Seebeck coefficient that is different from the Seebeck coefficient of said second material. Preferably, said first and second materials are alternatingly arranged along said strip or sheet so as to be electrically connected in series.

In an aspect, the invention provides a method for fabricating a thermoelectric device, the method comprising: producing a strip, sheet and/or film by providing successive, alternating sections of a first material, a second material, and, optionally, a third material; corrugating and/or folding said strip or sheet, so as to form a succession of peaks and/or top zones and low points and/or bottom zones along an extension of said strip or sheet; arranging said corrugated and/or folded strip or sheet on at least one support plate and/or between first and second, spaced apart plates.

In an aspect, the invention provides the use of a strip, sheet and/or film comprising alternating first and second materials capable of producing a Seebeck and/or a Peltier effect, in a thermoelectric device, preferably a thermoelectric generator.

In an aspect, the invention provides the use of roll-to-roll processing techniques in the fabrication of a thermoelectric device.

Further aspects and preferred embodiments of the invention are defined herein below and in the appended claims. Further features and advantages of the invention will become apparent to the skilled person from the description of the preferred embodiments given below.

### Brief Description of the Drawings

**Figures 1** **A, 1 B and 1 C** schematically show the layout and cross sections, respectively, of a device according to two embodiments of the invention, in which thermoelectric strips have a sinusoidal corrugation profile.
**Figures 2** **A, 2 B, 2 C** and **2 D** schematically show triangular, square, square overlapped, and sinusoidal embedded thermal junction corrugation profiles for the thermoelectric strips, respectively.
**Figure 3** schematically shows the inclusion of electrical interconnects between the thermoelectric materials of a corrugated thermoelectric strip according to an embodiment of the invention.
**Figure 4** **A** and **4 B** schematically show the encapsulation and/or coating of the corrugated thermoelectric strips according to embodiments of the invention.
**Figure 5** **A** and **5 B** schematically show thermoelectric devices conforming to a curved surface according to embodiments of the invention.
**Figure 6A** and **6B** schematically show the stacking and electric connection of individual thermoelectric generators, and the stacking and electrical connection of individual thermoelectric strips, respectively, in accordance with embodiments of the invention.
**Figure 7** **A** and **7 B** schematically show the addition of thermally conductive fins to the thermal junctions of the open side of the corrugated thermoelectric strips according to embodiments of the invention.

Hereinafter, preferred embodiments of the device of the invention are described with reference to the drawings, in order to illustrate the invention, without any intention to limit the scope of the present invention.

### Detailed Description of the Preferred Embodiments

In preferred embodiments, the present invention concerns a thermoelectric device, which may be used either as a thermoelectric generator (TEG), or as a thermoelectric cooler or heater, for example. Preferably, the device of the invention is capable of making use of the Seebeck effect and/or of the Peltier effect. In a preferred embodiment, the device is a TEG. Preferably, the device has two opposed main sides or surfaces, which main sides preferably provide the majority of the external surface of the device. Preferably, the device is capable of generating electricity in presence of a temperature gradient, for example if a flat surface of the device is situated in an orientation that is substantially perpendicular to the direction of the temperature gradient. More specifically, the device is capable of producing electric energy if it is arranged with respect to a temperature gradient in such a manner that the average temperature on one side of the device is higher than the average temperature on the other side of the device.

For the purpose of the present specification, the term "comprising" and its various grammatical forms is intended to mean "includes, amongst other". It is not intended to mean "consists only of".

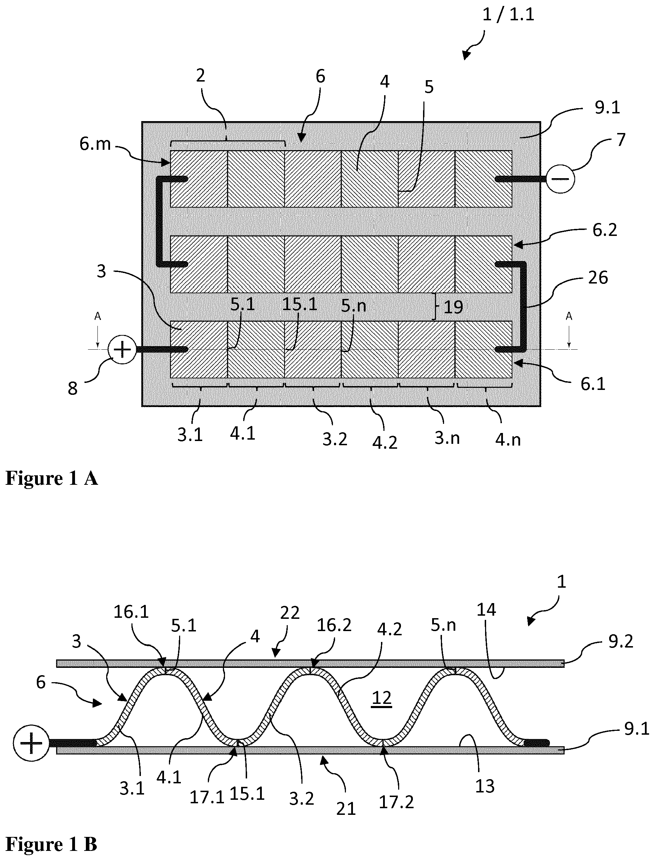

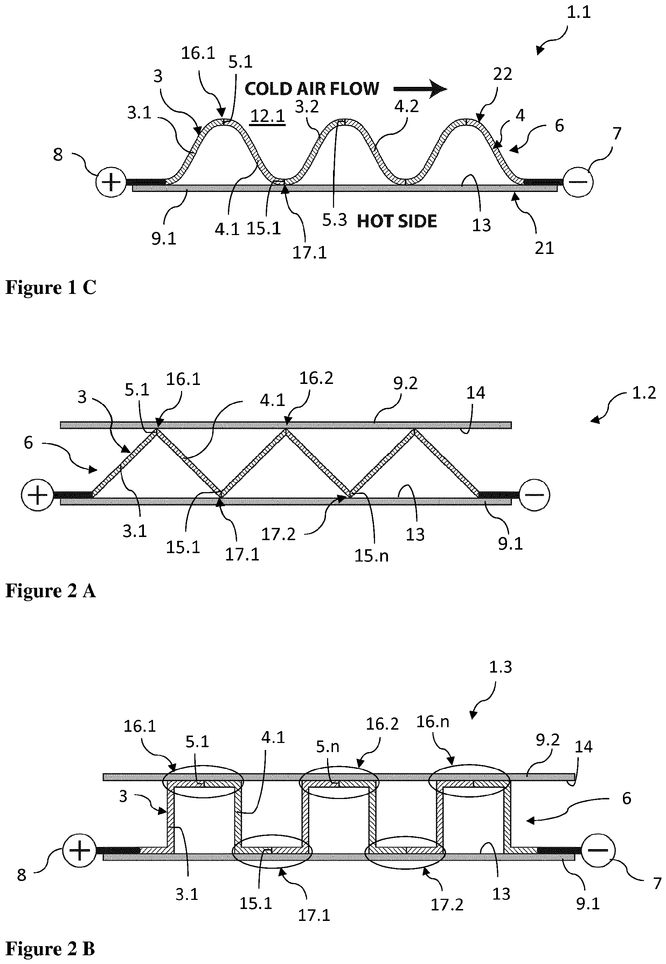

**Figures 1** **A, 1 B and 1 C** show first and second embodiments of devices **1** and **1.1** of the present invention. **Fig. 1** **A** can be regarded as a top-down view on the device of **Fig. 1** **B**, in which the top plate **9.2** has been removed, or as a top-down view of the device as shown in **Fig. 1** **C.** **Figs 1** **B and 1 C** are sections across the device shown in **Fig. 1** **A** at the line A-A. The only difference between the devices of **Figs 1** **B and 1 C** is the absence of the top plate **9.2 in** **Fig. 1** **C,** which is why **Fig. 1** **A** can be illustrative of both embodiments.

The thermoelectric generator comprises strips, sheets or films **6**, which extend along an overall horizontal, preferably straight direction. Preferably, each strip **6** is longitudinal. Each strip **6** comprises individual thermoelectric couples **2** that are electrically connected in series. Each thermoelectric couple **2** comprises two thermoelectric materials of differing Seebeck coefficients **3** and **4** that are electrically connected, where each connection **5**, **15** between the two materials of the strip **6** preferably defines a thermal junction. The strips **6** are then corrugated along their lengths such that the thermal junctions **5**, **15** are sequentially located at the maxima and minima of the corrugation profile **5** and **15**, or at least at high zones and low zones, respectively, of the corrugation profile. As a result, the thermoelectric couples **2** and strips **6** are electrically connected in series and thermally in parallel.

Reference numerals **5** and **15** are used in this specification to refer generally to any one or all the junctions **5.1-5.n** and **15.1-15.n** between the first and second materials, optionally including a third or intermediate material as described elsewhere in this specification. The letter "n" after a reference numeral is generally used to emphasise that the corresponding element preferably occurs repeatedly, several times and even many times as a result of the corrugated nature of the strip **6**, while the figures show generally only show two to three repetitions. The letter "n" can indicate that the corresponding structure appears more than 5 times, preferably more than 10 and, depending on the element referred to (e.g. sections of first and second materials, **3.n** ad **4.n**), more than 50 or even more than 100 times on a single strip.

For the purpose of the present specification, the term "strip" **6** is generally used, although it is understood that the materials **3**, **4** and, optionally **25**, may be associated in such a manner so as to provide any one or several selected from a strip, sheet, film, layer, multilayer and foil **6**, for example.

In an embodiment, said device comprises a plurality of strips **6.1, 6.2, ..., 6.m,** which are electrically connected in series, for example between spaced-apart plates **9.1, 9.2** or on top of a single plate **9.1**, thus covering an extended area.

It is noted that reference numeral **6** is generally used in this specification to refer to an exemplary strip or to the strips in general, whereas reference numerals **6.1, 6.2, ..., 6.m**, are used to emphasise that the device may comprise a plurality of individual strips and to refer to particular, individual strip, such as strip **6.1** in **Fig. 1** **A**, for example.

The individual strips **6.1-6.m** appearing horizontally in **Fig. 1** **A** are repeated in the vertical direction of **Fig. 1** **A** and connected electrically in series, thus allowing the thermocouples to cover a large area. Individual corrugated strips are thus preferably juxtaposed and/or aligned in rows **6.1, 6.2, ..., 6.m**, so as to efficiently cover an area as shown in **Fig. 1** **A.** The area may have any form, for example rectangular as shown in **Fig. 1** **A**, but also circular, elliptical, polygonal, and so forth.

Accordingly, in an embodiment, the device of the invention comprises a plurality of strips **6.1**, **6.2, ..., 6.m**, arranged one next to the other, preferably a plurality of juxtaposed strips. It is noted that the strip **6** is overall thin and longitudinal, such that the length (left-to-right direction in the figures) is larger than the width of the strip (bottom-top extension in **Fig. 1** **A**), and the width is larger than the thickness of the strip (top-bottom extension of the strip when shown in cross section, such as in **Figs 1** **B and 1 C**). Preferably, the width is at least twice, preferably at least 4 times as large as the thickness. Preferred widths and thickness of the strips **6** are provided elsewhere in this specification.

The materials **3** and **4** are preferably thermoelectric materials. Preferably, materials **3** and **4** are selected so as to produce a thermoelectric effect, in particular a Seebeck effect and/or a Peltier when used in combination, in particular when used in successive, alternating combination as shown in the figures. The Seebeck effect is preferably such that it is sufficient for the device to provide electrical energy when the device is used at the location of its intended use and/or application. Accordingly, the material **3** preferably has a different Seebeck coefficient than material **4**. In an embodiment, material **3** has a Seebeck coefficient with opposed sign (+/-) compared to the material **4**. Thermoelectric materials are known to the skilled person and new materials are to be discovered, and exemplary materials are cited elsewhere in this specification.

In an embodiment, said first and second materials **3**, **4** form sections **3.1, 4.1, 3.2, 4.2... 3.n, 4.n** of said strip or sheet **6**, said sections being alternatingly disposed along a direction of said strip or sheet **6**. In an embodiment, a pair of successive sections (e.g. **3.1** and **4.1**) of said first and second materials **3**, **4** form a thermoelectric couple **2**.

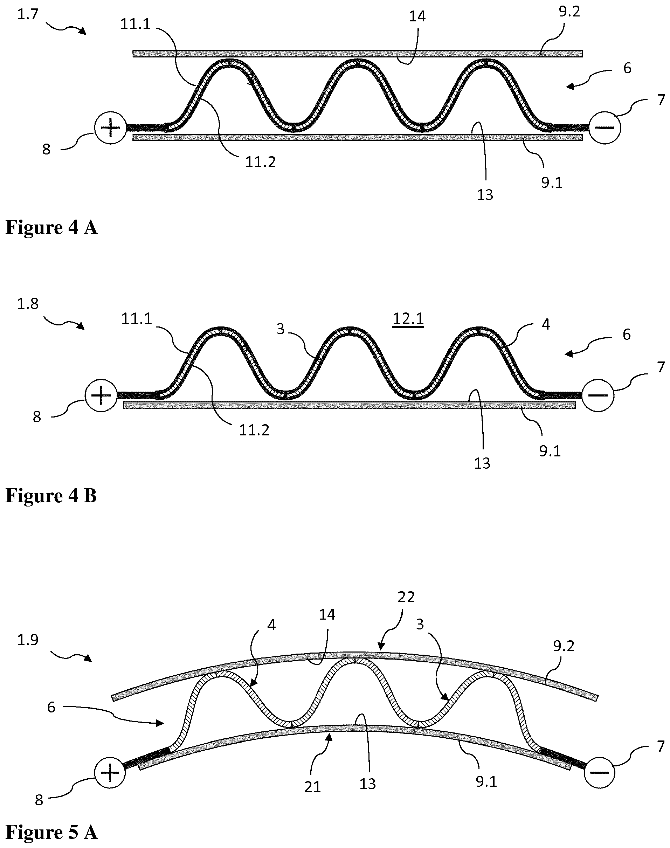

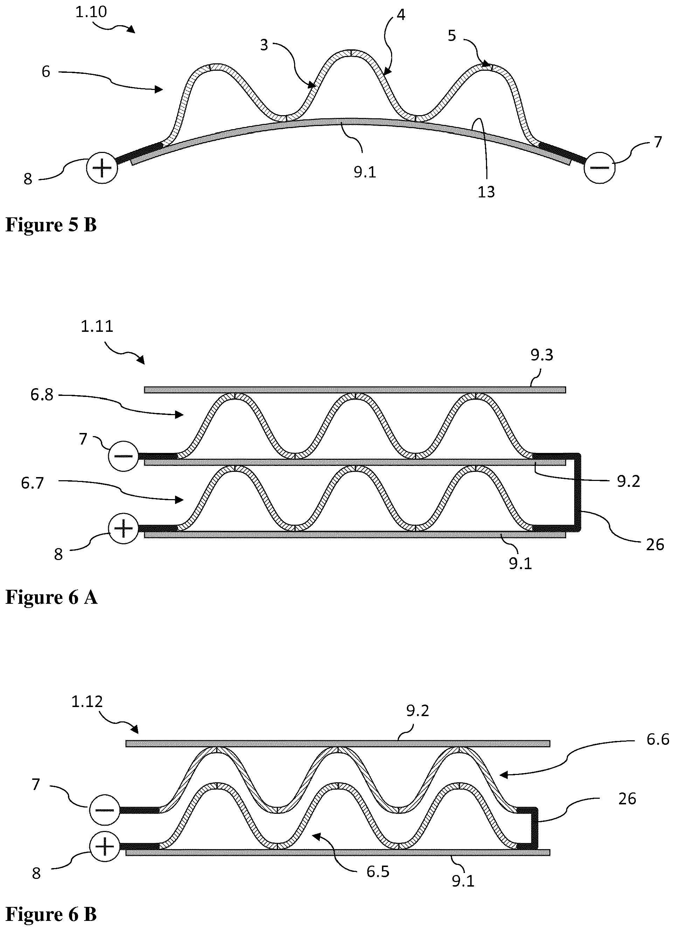

In the embodiment shown in **Figure 1** **B**, the corrugated thermoelectric elements are sandwiched between two flat plates **9.1** and **9.2**, which, in the embodiment shown, extend substantially in parallel one with respect to the other to form the thermoelectric generator **1**. The outer surfaces **21**, **22** of the plates **9.1** and **9.2** provide the main outer surfaces of the device. In a preferred embodiment, the outer surfaces **21**, **22** are overall flat and/or horizontal. In other embodiments, the plates **9.1** and **9.2** and, accordingly, the outer surfaces **21**, **22** of the device are not flat, but may be curved (**Fig. 5**). Preferably, the plates **9.1** and **9.2** provide regular and/or smooth outer surfaces.

In an embodiment, the device of the invention comprises a first plate **9.1** and a second plate **9.2**, wherein said first and second plates **9.1**, **9.2** are spaced apart such that said first plate **9.1** provides a first inner surface **13** and said second plate **9.2** provides a second inner surface **14** of said device **1**, wherein a space **12** is present between said first and second plates **9.1, 9.2**, and wherein said strip or sheet **6** is arranged in said space **12** in such a manner so as to alternatingly extend between said first and second inner surfaces **13**, **14** of said first and second plates **9.1**, **9.2**. The space **12** is preferably a space that is formed and/or delimited at least in the top and bottom direction by said first and second plates **9.1**, **9.2**.

In an embodiment, the distance by which plates **9.1**, **9.2** are spaced apart is substantially constant and the plates are substantially parallel. In other embodiments, the plates may not be entirely parallel one with respect to the other, or may not be parallel over the entire dimension or surface of the device.

In an embodiment, said strip or sheet **6** is disposed in said space **12** so as to alternatingly extend from an inner surface **13** of said first plate **9.1** to an inner surface **14** of said second plate **9.2** and back from said inner surface **14** of said second place **19.2** to said inner surface **13** of said first plate **9.1**.

In an embodiment, sections of said first material **3** repeatedly extend from an inner surface **13** of said first plate **9.1** to an inner surface **14** of said second plate **9.2,** and sections of said second material **4** extend from said inner surface **14** of said second place **19.2** back to said inner surface **13** of said first plate **9.1.**

As a result of the described arrangement of the device, when a thermal gradient is imposed across the thickness of the device, the thermal junctions in contact with the hotter plate define the hot junctions **5.1-5.n** and the thermal junctions in contact with the colder plate define the cold junctions **15.1-15.n** of the resulting thermoelectric generator (**Fig. 1** **B**); so that the individual thermocouples are thermally connected in parallel between the sandwiching plates. The resulting electrical voltage generated by the device, between the two ends **7**, **8** of the serially connected thermoelectric strips **6**, is proportional to the temperature difference between the hot and cold thermal junctions of the device. The strip width and thickness; separation between adjacent strips; the corrugation wavelength, height and profile; thermoelectric materials; and number of thermocouples comprising a strip strongly depend on the needs of particular applications of the thermoelectric device.

In an embodiment, illustrated in **Figure 1** **C**, the device of the invention comprises a support plate **9.1**, wherein said strip or sheet **6** is arranged on said plate **9.1** so as to alternatingly extend from a surface **13** of the plate **9.1** into the free space **12.1** above the plate **9.1** before bending back to again contact said surface **13**. In this embodiment, sections of said first material **3** repeatedly and/or constantly extend from an inner surface **13** of said support plate **9.1** into a space above, a high zone and/or to a peak **16.1-16.3** above said surface, and sections of said second material **4** extend from said space above, high zone and/or peak **16.1-16.3** back to the surface **13** of said support plate **9.1**.

The device of the embodiment shown in **Fig. 1** **C** comprises only one flat plate **9.1**, which preferably is a support plate, supporting the corrugated strip **6**. In this configuration, the peaks or high zones **16.1-16.3** of the corrugated strip or sheet **6** extend into free space above the plate **9.1**, as these peaks are not covered by the second plate. The lower, outer surface **21** of the device is provided by the outer surface of the support plate **9.1**, as in the previously described embodiments. On the other hand, in the absence of said top plate **9.2**, the upper outer surface **22** of the device corresponds preferably to the upper surface of the corrugated strip **6**. Preferably, the corrugation profile of the sheet or strip **6** is regular, such that different, successive high zones and/or peaks **16.1-16.3** have identical heights and overall identical dimensions and forms, so as to provide an overall regular, corrugated upper surface **22**. For this reason, the device remains overall flat, and still provides an overall flat appearance, created by the peaks and/or high zones on one of the two outer surfaces.

In the embodiment shown in **Fig. 1** **C**, the corrugated sheet can be attached to a single backing plate. In this case, if the backing plate **9.1** may be thermally attached to a hot surface and the top surface of the corrugated thermoelectric strip may be exposed to a colder fluid flow, such that the corrugations act like thermally conductive fins.

As a result of this, a temperature gradient is set up between the cold junctions **5.1-5.n** in the flow and the hot junctions **15.1-15.n** near the heated surface thus generating electrical power and assisting the convective cooling of the heat source (**Fig. 1** **C**). A similar but reversed situation arises if the backing plate is thermally attached to a cold surface with the corrugations exposed to a hotter fluid flow.

In an embodiment, said strip or sheet **6** is corrugated, forming preferably wavelike, sinusoidal, triangular, and/or square corrugation profiles. The corrugation profile of the strip or sheet **6** is visible in figures showing the device in section, preferably in a section along the longitudinal extension of the strips, as shown in **Figs. 1** **B**, **1 C**, **2 A-2 D**, and **3-7 B**.

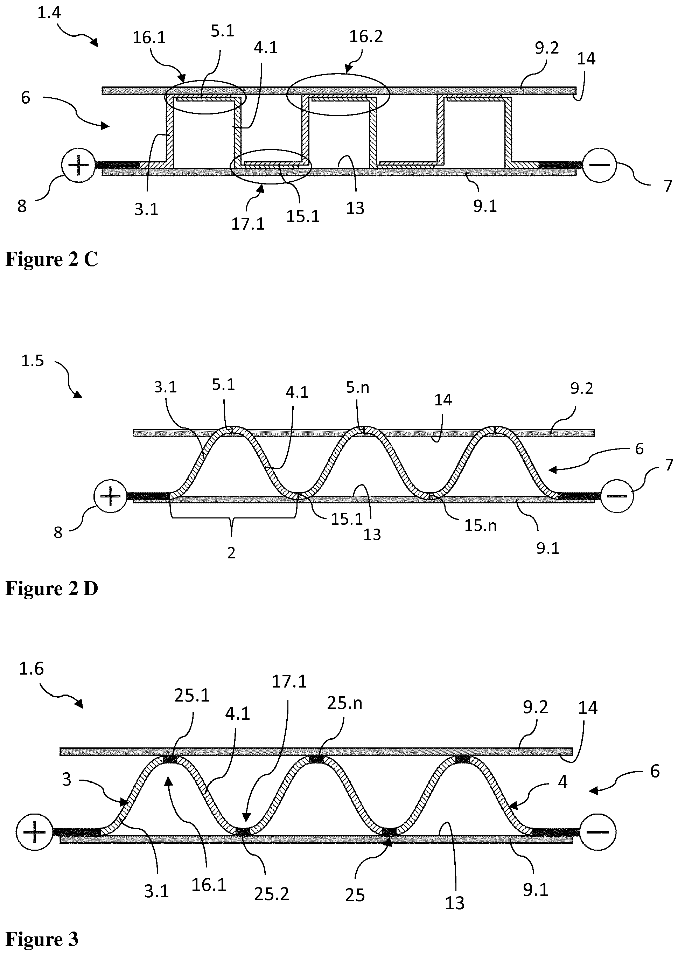

Any corrugation profile can be used to shape the thermoelectric strips **6** along their lengths. In the preferred embodiment of the invention this is a sinusoidal profile as shown in **Figs 1** **B** and **1 C**. In another embodiment of a device **1.2**, the strips **6** are arranged to provide a triangular profile as shown in **Fig. 2** **A**, whilst in another embodiment of device **1.3, 1.4**, it can be a square profile as shown in **Figs 2** **B and 2 C**.

The corrugation profile results in the device of the invention being a three-dimensional device. The two-dimensional extension of the device seen in **Fig. 1** **A** is completed by the height of the device (3^{rd} dimension) (bottom-top extension in **Figs 1** **B** through **7 B**), which is due to some extent and preferably to a major extent due to the corrugation of the strip 6. In the embodiments shown, the height of the device is determined by the corrugation profile of the strips, the thickness of the strips and the thickness of the support plate or plates **9.1** and or **9.2**, or by the support plate **9.1**, if a second plate **9.2** is absent.

The peaks or high zones **16.1-16.n** and low points or low zones **17.1-17.n** of the strip **6** are a consequence of the corrugation profile of the strip. Typically, the strip is formed as a succession of low points/zones and peaks/high zones. Preferably, a first material **3** extends from a low point **17.1** to a peak **16.2**, and a second material **4** extends from the peak **16.2** back to the next low point **17.2**, and so forth (or vice versa).

In the **Figs 2** **B and 2 C**, strips with square or rectangular corrugation profiles are shown. In this case, the strip does not specifically form "peaks" and "low points" as in the case of sinusoidal or triangular profiles as shown in **Figs 1** **B, 1 C** and **2 A.** The strips may actually comprise a flat part or section on the top and/or the bottom of the corrugation profile. In this case, one may consider the strip to provide high zones **16.1-16.n** and low zones **17.1-17.n.**

More generally, the corrugation profile of the strip **6** results in the spatial separation of high zones **16.1-16.n** and low zones **17.1-17.n.** The high zones are separated from the low zones in a vertical direction as shown in **Figs 1** **B** through **7 B**, as well as in the longitudinal, horizontal direction. The vertical distance between the high and low zones is preferably substantially constant, the corrugation profile being preferably regular. The vertical distance is preferably determined as the distance starting from the (inner) surface **14** of the support plate **9.1** in a direction perpendicular to the support plate and ending at the highest point of a high zone **16.1**, or ending at the inner surface **13** of the second plate if present. Individual, successive high zones **16.1, 16.2, 16.3** on a strip are preferably separated from each other along a horizontal direction, and the same applies to the successive individual low zones **17.1, 17.2.** In a device in use, the horizontal direction is the direction, curve, or profile along which the temperature gradient is preferably at a minimum, whereas the vertical direction is the direction along which the temperature gradient is preferably maximal.

As indicated above, there are junctions **5** where said first and second materials are connected with each other. Preferably, in the device of the invention, said junctions **5** etc. are spatially arranged so at to be close to or to substantially coincide with said peaks and low points **16.1-16.3** and low points **17.1-17.3** of the strip **6**. Preferably, sections of said material **3** start at a low point and extend to a subsequent peak, or vice versa, and sections of said material **4** extend from a peak and extend to the following peak, or vice versa, respectively. In other words, the two ends of each section **3.1, 4.1** of said material are at or close to a peak/high zone and/or low point/zone, respectively. In the embodiment shown in **Figures 1 A-1 C**, and **2 A-2 B**, the ends of the sections **3.1-3.n, 4.1-4.n** of the two materials are at the junctions **5.1-5.n** and **15.1-15.n** of the two materials, that is, at said high zones and low zones **16.1-16.n** and **17.1-17.n**, respectively.

The device **1.4** according to the embodiment shown in **Fig. 2** **C** illustrates junctions **5.1**, **5.15.1** formed by overlapping sections of first and second materials **3** and **4**. At a first junction **5.1**, here at a high zone **16.1**, the end of section **3.1** of a first material **3** is provided on, that is, vertically above the start of a subsequent section **4.1** of the second material. Once the second material is back at the subsequent bottom zone **17.1,** following the corrugation profile, at the next junction **15.1**, the start area of the subsequent section **3.2** of the first material is provided on, that is vertically directly above, the end area of the section **4.2** of the second material.

The arrangement of the first and second materials **3, 4** on the strip **6** as shown in **Fig. 2** **C** may typically be the result of a deposition process, in accordance with the method of the invention, where sections **3.1, 3.2, ..., 3.n** of the first material **3** are deposited or coated on previously deposited sections **4.1, 4.2, 4.n** of the second **4** material, such that overlaps at the ends and starts of the sections are formed, these overlaps being or contributing to the junctions **5.1-5.n and 15.1-15.n** between the first and second materials **3** and **4**.

In an embodiment of the invention, the thermoelectric strips can be laid out sequentially on or between the plates **9.1** and/or **9.2**, whilst in another they can comprise separate strips which are positioned independently on or between the plates **9.1** and/or **9.2**.

The thermoelectric strips can be aligned at any angle to the plate or plates whilst being electrically separated from each other along their lengths. In a preferred embodiment of the device, the thermoelectric strips are repeated regularly along the plates, such that their axes are parallel and the strips are separated along their lengths by a gap **19** as shown in **Figure 1** **A.**

In a preferred embodiment of the invention, the top and bottom plates **9.1, 9.2** of the device are made from single or multiple bonded layers of polymers, ceramics, metals, glasses, or composites. Preferably, the material of these plates or their top layers are electrically insulating to prevent electrical short circuit of the attached thermocouples **2**. Through holes (not shown) can be fabricated into these cover plates to provide electrical connections to the thermoelectric strips and/or ventilation of the internal volume, for example of the space **12** (**Fig. 1** **B**).

In an embodiment of the invention, the thickness of the plates **9.1** and **9.2** is preferably ≤ 5 mm, more preferably ≤ 3 mm, even more preferably ≤ 1 mm, and most preferably ≤ 0.5 mm.

In other embodiments of the invention, the thermal junctions **5.1-5.n** and **15.1-15.n** can be partially or be totally embedded into, or pushed through the thickness of the plates **9.1** and **9.2**, as shown in **Figure 2** **D**, such that they are closer and thus more efficiently thermally coupled to the attached heat sources.

The bottom **21** and/or top **22** surfaces of the thermoelectric generator are preferably suitably attached to the cooling and heating sources, preferably using thermal interface materials with low thermal conductivities, thus allowing electrical energy to be efficiently harvested.

The method of fabricating a thermoelectric device in accordance with the invention preferably comprises the step of corrugating and/or folding said strip or sheet **6**, so as to form a succession of peaks/high zones **16** and low points/zones **17** along an extension of said strip or sheet **6**, in particular along the longitudinal extension of said strip or sheet **6**. In an embodiment of the method of the invention, said step of corrugating and/or folding said strip or sheet **6**, said peaks and low points **16.1-16.n, 17.1-17.n** are preferably formed at junctions **5**, **15** between said first and second materials 3 and 4. In another preferred embodiment, the thermoelectric materials comprising the thermal couples are joined by an intermediate electrically conductive material **25 (25.1-25.n);** see **Figure 3**, which shows the embodiment **1.6** of the invention.

The association of the strips **6** on top of a support plate or between plates **9.1**, **9.2** may be conducted by roll to roll processing techniques, for example based on techniques used for producing corrugated cardboards. The step of arranging said corrugated and/or folded strip, sheet, or film on at least one support plate of the method of the invention may be conducted by such techniques.

In an embodiment, said strip or sheet **6** comprises at least a third material **25**, said third material being disposed between said first material **3** and said second material **4**, preferably being successively disposed between a section of said first material **3** and a section said second material **4**, said third material **25** preferably being electrically conductive and connecting said alternating first and second materials **3**, **4** in series. Preferably, said third material **25** is not a thermoelectric material and/or does not produce a measurable or significant thermoelectric effect but is used primarily for its conductivity and its suitability for connecting materials **3** and **4**.

In an embodiment, the third material **25** may provide or comprise sections **25.1, 25.2, 25.n** of said strip **6**, similar to what has been described with respect to said first and second materials **3, 4**. The sections **25.1**, **25.2**, **25.n** of the third material **25** do preferably not extend between the inner surfaces or from a surface to a peak or vice versa, as described with respect to said thermoelectric materials **3**, **4**. As the skilled person will understand, for the device to operate, it is preferable that the orientation of said thermoelectric materials in the device is such that it has a direction component that extends along the thermal gradient that is to be exploited or to be created (in the case of a cooling Peltier device). This is brought by the corrugation profile of the strip **6**. If the strip **6** was entirely flat and extending constantly in parallel to the support plate **9.1**, the efficiency of the device would be close the zero. This same finding does not apply to the third material **25**, which, when used in the strip **6**, is preferably provided so as not to contribute substantially to said direction component along the thermal gradient. Therefore, the material **25** extends preferably along sections that are substantially parallel to the plates **9.1**, **9.2**, that are in close vicinity to (or in thermal contact with) the plates, and/or is provided at the high zones **16** and/or low zones **17** of the strip **6**.

In an embodiment, said first and second materials **3**, **4** are disposed so as to form contacts or junctions **5**, **15** between them or with a third material **25**. In an embodiment, said strip, sheet or film **6** is disposed so that said junctions **5**, **15** are disposed at said inner surfaces **13**, **14**, preferably are in contact with said inner surfaces **13**, **14**. In the case of the device lacking a top plate **9.2** (**Fig. 1** **C**), a part of the junctions, such as junction **15.1**, are preferably on the support plate **9.1**, and the other part of the junctions, for example junction **5.2** subsequent to a junction **15.1**, is close to or at a free peak or top zone of the strip **6**. The third material **25** and/or sections thereof, if present, is preferably located at said junctions **5.1**, **5.2**.

In an embodiment, said strip **6** is disposed in a space **12** formed between said spaced-apart plates **9.1**, **9.2** such that junctions **5**, **15** between said first and second materials **3**, **4** are thermally connected to or associated with said inner surfaces **13**, **14**, and electrically isolated from said inner surfaces **13**, **14**, if present, said third material **25** is thermally connected to or associated with said inner surfaces **13**, **14**, but electrically isolated therefrom. The same applies to the embodiment shown in **Fig. 1** **C**, the only difference being that the top plate **9.2** is absent and the junctions (e.g. **5.3**) at the peaks **16.1-16.n** are not thermally connected to or associated with an inner surface of a plate. In this case, a moving cool or hot medium or fluid, such as cool air, provides a thermal interaction with said peaks and/or may provide the temperature gradient necessary for the device to operate, exactly as with the other embodiments.

In accordance with the method of the invention, said strip **6** is formed by a process comprising printing, electroplating, or coating said first, second and third materials **3**, **4**, **25**, preferably on a carrier substrate (not shown).

In another embodiment, said strip or sheet **6** is formed by a process of electrically bonding, fusing or soldering thin foils of said first, second and third materials **3**, **4**, **25**.

In an embodiment of the invention, the side edges of the device can be sealed to prevent the entry of moisture or dirt into the gap between the sandwiching plates, and to minimise the convection of fluids such as air along the corrugated channels. In preferred embodiments, this sealed volume can be either evacuated or filled with a fluid to increase the thermal resistance of the device. In another embodiment, the side edges of the device are unsealed, thus allowing a fluid to flow along the corrugations for thermal management of the device.

In an embodiment of the invention, the width of the corrugated thermoelectric strips is preferably ≤ 5 cm, more preferably ≤ 3 cm, even more preferably ≤ 2 cm, and most preferably ≤ 1 cm.

In an embodiment of the invention, the height of the corrugated thermoelectric strips, and thus the distance between the sandwiching plates (where present) is preferably ≤ 2 cm, more preferably ≤ 1 cm, even more preferably ≤ 5 mm, and most preferably ≤ 2 mm.

In an embodiment of the invention, the gap **19** between adjacent corrugated thermoelectric strips is preferably ≤ 2 cm, more preferably ≤ 1 cm, even more preferably ≤ 5 mm, and most preferably ≤ 1 mm.

In an embodiment of the invention, the wavelength of the corrugation along the corrugated thermoelectric strips is preferably ≤ 3 cm, more preferably ≤ 1 cm, even more preferably ≤ 5 mm, and most preferably ≤ 1 mm.

In an embodiment of the invention, the surface area of each side of the sandwiched corrugated thermoelectric device is preferably ≤ 10 m², more preferably ≤ 5 m², even more preferably ≤ 1 m², and most preferably ≤ 0.5 m².

The thermoelectric materials are preferably in the form of thin films or foils. These materials can comprise metals, semiconductors, ceramics, and organic compounds. In a preferred embodiment of the invention, they are a copper and nickel, in another they are aluminium and nickel, in another they are constantan and nichrome, whilst in yet another they are *n* and p doped bismuth telluride semiconductors.

Typical values for the differential Seebeck coefficient of common thermocouples in (µV/K) are: nickel-aluminium = 18.5, nickel-copper = 21.5, constantan-nichrome = 60, and bismuthtellurium = 572. Preferably, the differential Seebeck coefficient of the thermocouple in the device of the invention is ≥5 µV/K, preferably ≥10 µV/K and most preferably ≥15 µV/K.

In an embodiment, the thickness of the thermoelectric materials (strip, sheet, layer, foil, multilayer, etc.) comprising the corrugated thermoelectric strip **6**, including said first and second and optionally third materials **3**, **4** and **25**, is ≤ 5 mm, preferably ≤ 1 mm, more preferably ≤ 0.5 mm, even more preferably ≤ 0.2 mm, and most preferably ≤ 0.1 mm. This thickness preferably corresponds to the vertical extension of the strip as shown in Figs 1 B through 5 B, assuming that the corrugated profile was absent and the strip deposited as an essentially flat film on the plate **9.1**.

The thermoelectric materials may be either inkjet printed or screen printed, electroplated, electroless plated, or placed as thin foils onto suitable electrically insulating rigid or flexible substrates. It is important to provide good electrical and thermal bonding between adjacent thermoelectric materials, either edge to edge or overlapped, to ensure an efficient thermoelectric device. In preferred embodiments of the invention, adjacent materials can be bonded using reactive bonding, in another using diffusion bonding, whilst in a third using solder bonding.

In a preferred embodiment of the invention, the substrate **9.1**, **9.2** is a polymer sheet, in another it can be wood/cellulose fibre sheets, in another a composite sheet, whilst in another it can be ceramic. In an embodiment, the thickness of the substrate material is ≤ 2 mm, preferably ≤ 1 mm, more preferably ≤ 0.5 mm, even more preferably ≤ 0.1 mm, and most preferably ≤ 0.05 mm.

In an embodiment, the device and/or strip **6** further comprises a protective layer **11** disposed on one or more surfaces of said strip or sheet **6**, said protective layer **11** being preferably coated and/or deposited on said strip or sheet **6**.

**Figure 4** **A and 4 B** show devices **1.7** and **1.8** in accordance with embodiments of the invention, in which, in order to prevent electrical short circuit between thermocouples, the thermoelectric materials comprising a thermoelectric strip can be encapsulated between two electrically insulating flexible polymer sheets **11.1**, **11.2.** In another embodiment, thermoelectric materials **3**, **4** can be sprayed with suitable insulating coatings **11.1/11.2** which are then cured. The insulating layers or coating **11.1**, **11.2** may cover said strip **6** totally or partially, for example specifically at the contact points with the plate **9.1** and **9.2**, in as far as present. In other embodiments, the thermoelectric strip **6** may only be insulated on one side.

In some embodiments, for example **1-1.8** and **1.11-1.14**, the devices of the present invention are rigid and flat. However, the devices **1.9** and **1.10** of the embodiment shown in **Figures 5** **A** and **5 B** comprise a curved surface. Preferably, the device and its surfaces are rigid so as to maintain their flat or curved appearance when exposed to an external force. The rigidity is preferably provided by said one or two plates **9.1**, **9.2.** In another embodiment of device **1.10** shown in **Figure 5** **B**, the backing plate **9.1** can remain flexible after manufacture of the device, thus allowing the thermoelectric generator to be easily wrapped around and suitably thermally bonded to a curved surface for a given application.

In order to generate a larger voltage from a given thermal gradient, or to accommodate larger thermal gradients, the thermoelectric devices can be stacked and electrically connected.

In an embodiment **1.11** of the invention, the individual sandwiched thermoelectric generator devices **1** may be stacked as shown in **Figure 6** **A**. the device of the invention comprises a third plate **9.3**, wherein said strip is a first strip **6.7**, said device further comprising a second strip **6.8** disposed between said third plate **9.3** and one selected from said first plate **9.1** and said second plate **9.2.** Preferably, said third plate is spaced apart from said second plate, for example substantially parallel to said second plate. In an embodiment, the third plate is above said second plate. In an embodiment, said second strip **6.8** being preferably connected in series with said first strip **6.7**.

In another preferred embodiment **1.12** of the invention, two or more strips **6.5-6.6** may be layered, stacked and/or superimposed. In case the device comprises two or more plates, said two or more strips **6.5-6.6** may be layered, stacked and/or superimposed between said first and second plates **9.1**, **9.2** as shown in **Figure 6** **B**, resulting in a multi-layered device. Such a multi-layered device may also comprise a single support plate as shown in Figs 1 C and 5 B and may be coated with a coating or insulating layer as shown in Figs. 4 A and 4 B.

In an embodiment, said layered, stacked and/or superimposed strips **6.5-6.6** are disposed such that a section of said first material **3** in a first strip **6.5** is aligned with and/or vertically adjacent to a section of said second material **4** in a second strip **6.6**. In an embodiment (not shown), an insulating layer **11** is provided between layered, stacked and/or superimposed strips **6.5-6.6.**

In other preferred embodiments of the invention, the thermoelectric strips on the top and/or bottom surfaces of the stacked devices may be left unbounded by a plate **9.1** and/or **9.2**.

In an embodiment of the invention the number of individual devices or strips that are stacked is ≤ 10, preferably ≤ 5, more preferably ≤ 3, and most preferably 2.

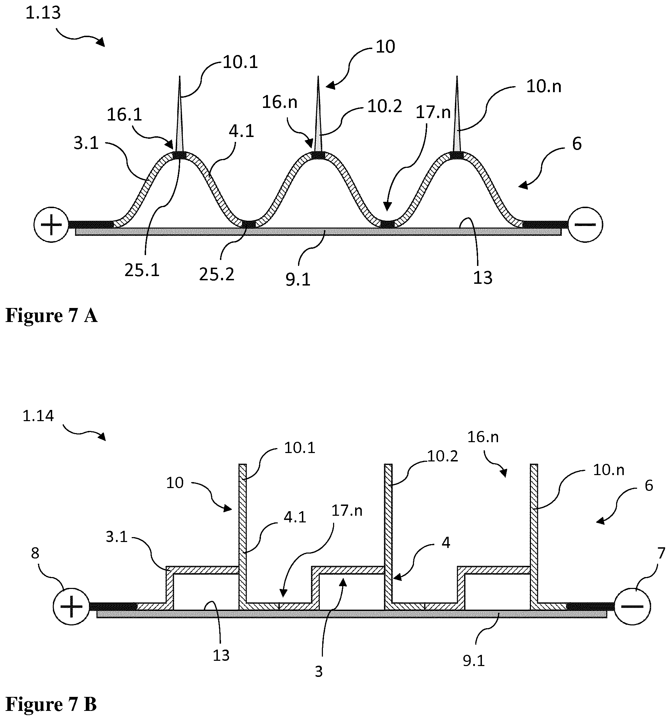

In an embodiment, illustrated in **Figs 7** **A** and **7 B**, the device of the invention comprises junctions **5**, **15** between said first and second materials **3**, **4**, and thermally conductive fins **10** are provided at least some of said junctions **5**, **15**, preferably at exposed junctions **5**. The exposed junctions are those junctions **5** at the top zones **16** of the strip **6** in devices where a top or second plate **9.2** is absent (**Figs. 1** **C**, **4 B**, **5 B**, **7 C**). The exposed junctions **5** are thus opposed to the junctions **15** that are in contact with the support plate **9.1.** Furthermore, the exposed junctions **5** extend into the free space **12.1** above the support plate **9.1**.

The thermally conductive fins **10** can be integrated onto the exposed thermoelectric strips such that the flow of the fluid over these fins enhances the heat transfer from heat sources attached to the lower plate **21** by thermal convection, thus providing thermal management and enhancing the available temperature difference.

In the embodiment **1.13** shown in **Figure 7** **A**, thermally conductive fins **10.1-10.n** can be attached to the exposed thermal junctions **5** of the thermoelectric strips. These fins can be made from different or similar material than **3** and **4**. In another embodiment **1.14**, shown in Figure **7** **B**, the material of either **3** or **4** can be extended to form a thermally conductive fin **10**. The fins **10** may be integrated into or be part of the corrugation profile of the strip and/or of said first, second and/or third material **3**, **4**, **25**, in as far as present. In either embodiment, any fin geometry, cross sectional profile, and size can be used with the exact design being strongly related to the application. Applied fin types can include louvered, wavy, split, branched, staggered, inline, and tapered.

In an embodiment of the invention, the heat source may originate from incident solar radiation. In other embodiments, the heat source may originate from sources such as combustion, chemical reactions, mechanical friction, incident radiation, Joule heating of electronics, or heat generated from a living being, for example a mammal.

In an embodiment of the invention, since the Seebeck-Peltier effect is reversible, the device can be used to provide heating or cooling by the application of a voltage to its electrical connectors **7** and **8**.

Preferably, the described embodiments provide a passive sealed device with no moving parts, thus preferably implying a reliable low maintenance autonomous operation over long time scales. The devices of the invention may be manufactured as cheap, thin, and low-weight units which can be easily integrated into systems.

Because of its design and benefits, the present invention is well suited for the economic conversion of thermal energy into electrical energy over large surface areas exposed to solar radiation. Applications of the described invention include use as backing panels to photovoltaic cells or as standalone solar collectors.

It is noted that the various embodiments shown in different figures may be combined and the present invention expressly encompasses such combination. For example, the devices shown in **Figs 1 A-1 C**, **2 A-2 D**, **4 A-4 B**, **5 A-5 B**, **6 A-6 B**, and **7 A-7 B** may comprise a conductive material **25** between the two materials **3**, **4** having different Seebeck coefficients. Similarly, any one of the device shown in the figures or described in the present specification may comprise one or more insulating layers as shown in **Figs 4** **A and 4 B**, for example. Furthermore, any one of the devices shown in the figures may be stacked, for example as illustrated in any one of **Figs 6** **A** and **6 B**. As a further example, any one of the devices shown in the figures may be provided to have a curved surface as shown in **Figs 5** **A and 5 B**, or may contain only one plate as illustrated in **Fig. 1** **C**. For example, the embodiment shown in **Figs 1** **C**, preferably lacking the rigid top plate may be curved (as shown in **Fig. 5** **C**), may comprise a conductive material **25**, may comprise a coating **11**, may have any corrugation profile as illustrated in **Figs 1** **C**, **2 A-2 D**, and may be stacked. The same applies of course to the embodiment shown in **Fig. 1** **B**.

While certain of the preferred embodiments of the present invention have been described and specifically exemplified above, it is not intended that the invention be limited to such embodiments. Various modifications may be made thereto without departing from the scope and spirit of the present invention, as set forth in the following claims.

## Claims

1. A thermoelectric device (1) comprising a strip, sheet, or film (6) comprising first and second materials (3,4), wherein said first material (3) has a Seebeck coefficient that is different from the Seebeck coefficient of said second material (4), said first and second materials (3,4) being alternatingly arranged along said strip, sheet, or film (6) so as to be electrically connected in series.

2. The device (1) of claim 1, wherein said strip, sheet, or film (6) is corrugated, forming preferably wavelike, sinusoidal, triangular, and/or square corrugation profiles.

3. The device (1) of any one of claims 1 or 2, wherein said first and second materials (3, 4) form sections (3.1, 3.1, 3.n; 4.1, 4.2, 4.n) of said strip, sheet, or film (6), said sections being alternatingly disposed along a direction of said strip or sheet (6).

4. The device (1) of any one of the preceding claims, wherein said strip, sheet, or film (6) comprises at least a third material (25), said third material being disposed between said first material (3) and said second material (4), preferably being successively disposed between a section of said first material (3.1) and a section said second material (4.1), said third material (25) preferably being electrically conductive and connecting said alternating first and second materials (3, 4) in series.

5. The device (1) of any one of the preceding claims, wherein a pair of successive sections (3.1, 4.1) of said first and second materials (3, 4) form a thermoelectric couple (2).

6. The device (1) of any one of the preceding claims, further comprising a protective layer (11, 11.1, 11.2) disposed on one or more surfaces of said strip, sheet, or film (6), said protective layer (11, 11.1, 11.2) being preferably coated and/or deposited on said strip, sheet, or film (6).

7. The device of any one of the preceding claims, comprising a support plate (9.1), wherein said strip, sheet or film (6) is arranged on said plate (9.1) so as to alternatingly extend from a surface (13) of the plate (9.1) into the space (12.1) above the plate (9.1) or above the surface (13), before bending back to again contact said surface (13).

8. The device of any one of the preceding claims, comprising junctions (5, 15) between said first and second materials (3, 4), and wherein thermally conductive fins (10) are provided at at least some of said junctions (5, 15), preferably at exposed junctions (5).

9. The device of any one of the preceding claims, comprising a first plate (9.1) and a second plate (9.2), wherein said first and second plates (9.1, 9.2) are spaced apart such that said first plate (9.1) provides a first inner surface (13) and said second plate (9.2) provides a second inner surface (14) of said device (1), wherein a space (12) is present between said first and second plates (9.1, 9.2), and wherein said strip, sheet or film (6) is arranged in said space (12) in such a manner so as to alternatingly extend between said first and second inner surfaces (13, 14) of said first and second plates (9.1, 9.2).

10. The device (1) of any one of the preceding claims, wherein said first and second materials (3, 4) are disposed so as to form contacts or junctions (5, 15) between them or with a third material (25) provided between said first and second materials (3, 4), wherein said strip, sheet or film (6) is preferably arranged so that said at least some of said junctions (5, 15) are disposed at said surface (13) or surfaces (13, 14), and are preferably in contact with said inner surfaces (13, 14) or with a top surface (13) of a support plate (9.1).

11. The device (1) of any of claims 7-10, comprising junctions (5, 15) between said first and second materials (3, 4), wherein said junctions (5, 15) are partially or totally embedded or pass through said support plate (9.1) or any one or both of said first and second plates (9.1, 9.2).

12. The device (1) of any one of the preceding claims, comprising two or more strips, sheets, or films (6.5-6.6), which are layered, stacked, and/or superimposed.

13. The device of any one of claims 9 to 12, comprising a third plate (9.3), wherein said strip is a first strip (6.7), said device further comprising a second strip (6.8) disposed between said third plate (9.3) and one selected from said first plate (9.1) and said second plate (9.2), said second strip (6.8) being preferably connected in series with said first strip (6.7).

14. A method for fabricating a thermoelectric device (1), the method comprising:
- producing a strip, sheet or film (6) by providing successive, alternating sections (3.1, 4.1) of a first material (3), a second material (4), and, optionally, a third material (25);
- corrugating and/or folding said strip, sheet, or film (6), so as to form a succession of top zones or peaks (16) and low points or bottom zones (17) along an extension of said strip or sheet (6);
- arranging said corrugated and/or folded strip, sheet, or film (6) on at least one support plate (9.1, 9.2).

15. Use of a strip, sheet, or film (6) comprising alternating first and second materials (3,4) capable of producing a Seebeck and/or a Peltier effect, in a thermoelectric device, preferably a thermoelectric generator.

16. The method of claim 14, wherein in said step of corrugating and/or folding said strip, sheet, or film (6), said top zones or peaks (16.1-16.n) and bottom zones or low points (17.1-17.n) are formed at junctions (5, 15) between said first and second materials (3, 4) or at sections of said third material (10).

17. The device (1) of any one of claims 1 to 13, wherein said device comprises a plurality of strips, sheets, or films (6.1, 6.2, ..., 6.m), which are electrically connected in series, either between said spaced-apart plates (9.1, 9.2) or on top of a single plate (9.1), thus preferably covering an extended area.

18. The device of claim 12, wherein an insulating layer (11) is provided between layered, stacked and/or superimposed strips (6.5-6.6).
